# EUROPEAN PATENT APPLICATION

(11) **EP 3 163 901 A1**
(43) Date of publication of application: **03.05.2017**
(21) Application number: 15192423.0
(22) Date of filing: 30.10.2015
(51) Int. Cl.: H04R 1/10, H03K 17/94, H03K 17/945, H03K 17/96

(54) **A HEADSET FOR CONTROLLING AN ELECTRONIC APPLIANCE**

(71) Applicant: Advanced Digital Broadcast S.A., 1292 Chambesy (CH)
(72) Inventor: Digioia, Michele, 20126 Milano (IT)
(74) Representative: Kancelaria Eupatent.pl Sp. z.o.o

(57) **Abstract**

A headset for controlling an electronic appliance, comprising a first earpiece (1) and a second earpiece (2), characterized in that it further comprises a first control unit (6) associated with input means (5) located in the first earpiece (1); a second control unit (7) associated with input means (5) located in the second earpiece (2); wherein the input means (5) comprise sensors for detecting hand-performed actions of a user of the headset; communication means (104, 105) for connecting with the electronic appliance, wherein the connection allows to control selected parameters of the electronic appliance, said selected parameters being divided into at least a first parameter group and a second parameter group; wherein the first control unit (6) is configured to control the first parameter group upon detection of a predefined hand-performed action with respect to the input means (5) located in the first earpiece (1); and wherein the second control unit (7) is configured to control the second parameter group upon detection of a predefined hand-performed action with respect to the input means (5) located in the second earpiece (2).

## Description

### TECHNICAL FIELD

The present invention relates to a device, having a form of a headset, for controlling electronic appliances, such as a TV system, an AV receiver and similar.

### BACKGROUND

A remote control unit (RCU) or a remote controller is a consumer electronics device designed for operating with a TV receiver or an AV receiver. Nowadays almost every television set is supplied with remote control unit having plurality of pushbuttons providing necessary commands for setting and adjusting of the TV system. As television sets become more and more complicated devices, the number of commands and therefore pushbuttons has notably increased. Consequently, the dimensions of the remotes controls increased as well. It may be troublesome for a user to keep the RCU of a significant size at hand all the time. Larger number and density of pushbuttons make the control of a TV system complicated and inconvenient. Furthermore, majority of options is not used by the user for everyday operation - the most commonly used functions are volume adjusting and program selection, plus a standby function.

A US patent US5973757A discloses a hand-held TV/computer remote infrared control device having an elongated rectangular housing. Remote control device comprise various control buttons, disposed on the top side in front of the device. A computer pointing structure, in form of a track ball and two associated selection buttons is disposed on the top side at the rear of the device. The device disclosed in the document comprisees some features which give a user more comfort when using it. Appropriately balanced structure of the device, makes is stable against forward tipping when holding in user's hand. Front part of the device is slightly tipping upward, making the buttons more visible to the user. The drawback of the presented remote device is that it is still equipped with vast number of control buttons, which make it more difficult for the user to find an appropriate one. Moreover a device is prone to be lost, and still is an additional object to be handled around by a user.

Another commonly used consumer electronic device are headphones. A well-known headphone apparatus comprises a headband and two earpieces. While a common practice is to install a volume potentiometer in the line of connecting cable, its control abilities are severely restricted.

A US patent US7853035B2 discloses a pair of headphones that include a headband having a pair of support arms and a pair of angularly movable housings mounted on the support arms. The disclosed invention relates to the pair of headphones for use as wireless headphones. However such headphones' device does not comprise any means for controlling any external device.

It is an aim of the present invention to propose an alternative device for controlling electronic appliances, such as a TV system, an AV receiver, a radio receiver or a mobile phone that would free the user from the necessity of carrying the RCU unit or remembering its location within the user space, while in the same time allow for less complicated and more intuitive control of such electronic appliances.

### SUMMARY

The object of the invention is a headset for controlling an electronic appliance, comprising a first earpiece and a second earpiece, characterized in that it further comprises a first control unit associated with input means located in the first earpiece; a second control unit associated with input means located in the second earpiece; wherein the input means comprise sensors for detecting hand-performed actions of a user of the headset; communication means for connecting with the electronic appliance, wherein the connection allows to control selected parameters of the electronic appliance, said selected parameters being divided into at least a first parameter group and a second parameter group; wherein the first control unit is configured to control the first parameter group upon detection of a predefined hand-performed action with respect to the input means located in the first earpiece; and wherein the second control unit is configured to control the second parameter group upon detection of a predefined hand-performed action with respect to the input means located in the second earpiece.

Preferably, the first parameter group comprises selection of a function, and the second parameter group comprises selection of a parameter of the selected function.

Preferably, the parameter groups are assigned dynamically based on detection of predefined conditions.

Preferably, the control of the parameter groups triggers playing an audio descriptor associated with control parameter through at least one earpiece.

Preferably, the input means are pushbuttons.

Preferably, the input means are touch sensors.

Preferably, the input means are proximity sensors.

Preferably, the input means are optical sensors.

Preferably, the input means are gyroscopes or accelerometers.

### BRIEF DESCRIPTION OF DRAWINGS

Further details and features of the present invention, its nature and various advantages will become more apparent from the following detailed description of the preferred embodiments shown in drawings, in which:
Fig. 1 shows exemplary embodiment of a headset in a front view;
Fig. 2 shows exemplary embodiment of headset in a side view;
Fig. 3 shows locations of transmitting points and directions of infrared wave propagation;
Fig. 4 shows an example of coordinate system of the headset;
Fig. 5 shows an example of coordinate system of the headset in relation to users head;
Fig. 6 shows a schematic diagram of headset system.

### NOTATION AND NOMENCLATURE

Some portions of the detailed description which follows are presented in terms of data processing procedures, steps or other symbolic representations of operations on data bits that can be performed on computer memory. Therefore, a computer executes such logical steps thus requiring physical manipulations of physical quantities.

Usually these quantities take the form of electrical or magnetic signals capable of being stored, transferred, combined, compared, and otherwise manipulated in a computer system. For reasons of common usage, these signals are referred to as bits, packets, messages, values, elements, symbols, characters, terms, numbers, or the like.

Additionally, all of these and similar terms are to be associated with the appropriate physical quantities and are merely convenient labels applied to these quantities. Terms such as "processing" or "creating" or "transferring" or "executing" or "determining" or "detecting" or "obtaining" or "selecting" or "calculating" or "generating" or the like, refer to the action and processes of a computer system that manipulates and transforms data represented as physical (electronic) quantities within the computer's registers and memories into other data similarly represented as physical quantities within the memories or registers or other such information storage.

### DETAILED DESCRIPTION

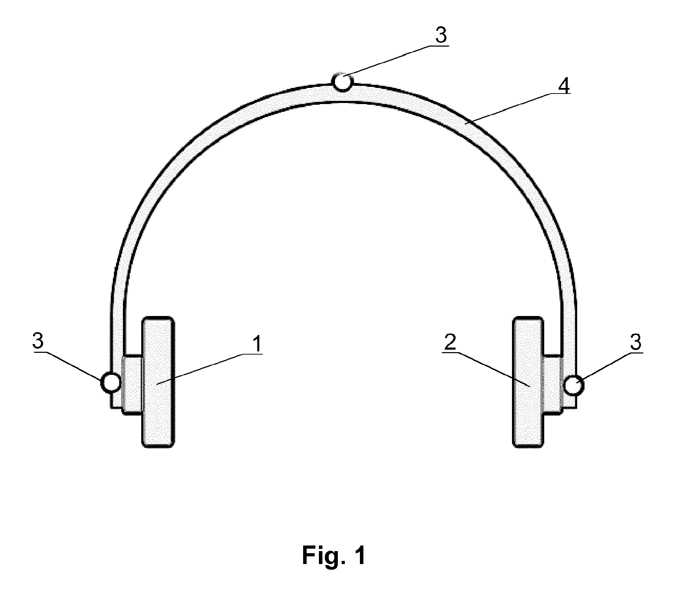

Fig. 1 shows an exemplary embodiment of a headset in a front view. The headset comprises a first earpiece 1 and a second earpiece 2 joined by a headband 4 and connected to each other by a wire or wirelessly. The headset comprises input means 5 that have sensors for detecting control instructions in form of hand-performed actions of the user. The input means 5 having sensors are understood as any kind of devices which are able to transform actions performed physically a user, into electrical signals. Control instructions are performed using hands - in particular through a physical contact, interaction using force, hand movements and/or hand gestures. The control instructions may be detected from a first hand and from a second hand. In particular, the first hand can be a left hand and the second hand may be a right hand of a user.

The headset further comprises a first control unit 6 associated with the first earpiece 1 and a second control unit 7 associated with the second earpiece 2. The control units 6, 7 are configured to transmit signals to a processor 103, wherein these signals represent control instructions coming from input means 5 located in the first control unit 6 and the second control unit 7. Subsequently, these signals can be converted into an output signal. The headset further comprises communication means 104, 105 for connecting with the electronic appliance to be controlled, wherein such connection allows to control selected parameters of the electronic appliance. Said selected parameters are divided into at least a first parameter group and a second parameter group. The division of parameters into groups allows them to be operated in pairs separately through the input means 5 of the first earpiece 1 and of the second earpiece 2. This in turn leads to flexibility with respect to both static and dynamic allocation of functions of the device to be controlled. The communication means may be an unidirectional 104 communication means (e.g. infrared (IR)), or bidirectional 105 communication means (e.g. WiFi, Bluetooth or other wireless or wired communication systems). Upon detection of a predefined hand-performed action with respect to the first earpiece 1, the first control unit 6 controls the first parameter group. Analogously, upon detection of a predefined hand-performed action with respect to the second earpiece 2, the second control unit 7 controls the second parameter group. This maximizes the functionality of the remote control while retaining the straightforward, ergonomic operation. Such solution allows also to easily adapt the headset to the particular device to be controlled, and makes the headset universal.

A communication signal is transmitted to the electronic appliance, such as a TV system, an AV receiver, or a mobile phone. The communication signal is received by the appliance. Thus a remote adjustment of controllable parameters of the electronic appliance is possible.

The control units 6, 7 have assigned parameter groups, which correspond to adjustment and/or selection of predefined options. The parameter groups can be assigned once and kept in memory without changing them. The parameter groups can also be assigned dynamically, depending on the current conditions. For example, when the headset is paired with a TV set, and a DVD player becomes active, the headset may pair with the DVD player and assume new parameter groups that may or may not be concise with those of the TV set - for example, volume adjustment or chapter selection.

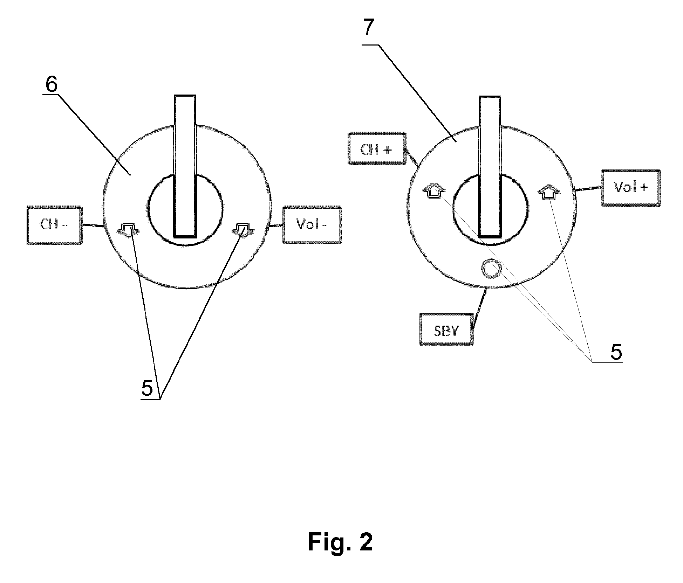

Fig. 2 shows an example of input means 5 implementation. The control input means 5 may have a form of pushbuttons. In the presented embodiment, five separate buttons are present in the control units 6, 7 implemented in the headset: Vol+ (Increase the sound volume), Vol- (Decrease the sound volume), CH+ (Move one channel up), CH- (Move one channel down), SBY which stand for (Setting a TV set into standby mode). The low number of input means 5 makes it easy to remember their positions, thus enabling a user an intuitive control over the controlled electronic appliance. While using a standard remote control unit, with a plurality of pushbuttons representing many functions and settings, especially in dark conditions, it may be difficult to find a pushbutton for desired function. A proper selection of most used functions and providing means to control them with headset significantly improves the ergonomics of the control.

In another example, the input means 5 of the control unit 6 of the first earpiece 1 can be responsible for decreasing the selected parameters, while the input means 5 of the control unit 7 of the second earpiece 2 can be responsible for increasing the selected parameters. For example, the first earpiece 1 can comprise the input means 5 in form of pushbuttons "Vol -" and "CH -", while the second earpiece 2 can comprise input means 5 in form of pushbuttons "Vol +", "CH +" and "SBY". In other words, the first earpiece can be responsible for lowering the sound volume and decreasing the current channel number, while the second earpiece 2 can be responsible for increasing the sound volume and increasing the current channel number.

The input means 5 of the control unit 6 of the first earpiece 1 can be responsible for increasing and decreasing the parameters of a first parameter group, while the input means 5 of control unit 7 of the first earpiece 2 can be responsible for increasing and decreasing the parameters of a second parameter group. For example, the left earpiece control unit 6 can be used to select channels, while the right earpiece control unit 7 can be used for volume adjusting and standby functions.

Alternatively, the first control unit 6 may comprise input means 5 for choosing a function (changing a parameter from the first parameter group that is responsible for activating specific function), while the second control unit 7 may comprise input means 5 for adjusting the parameter of a function chosen by the first control unit 6 (controlling a parameter from the second parameter group that corresponds to activated specific function). For example, the user may select channel adjustment by interacting with the left earpiece using the left hand and may adjust the channel number by interacting with the right earpiece using the right hand.

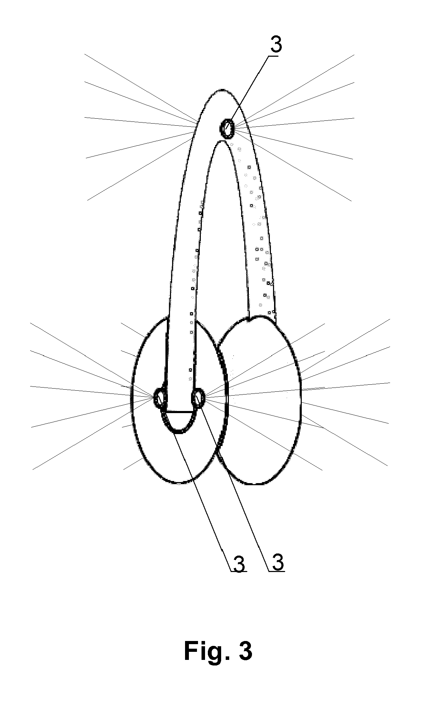

The control units 6, 7 can transmit signals to the controlled device by means of the communication means 104, 105. In case the communication means include an infrared transmitter 3, there may be a plurality of transmitters 3 positioned in several places distanced with respect to each other. Such arrangement can help prevent physical obstacles, for example hair or a hand, from obstructing the signal path, as shown in Fig. 3. The IR transmitters 3 can be devices capable of emitting an infrared signal, preferably infrared diodes. The IR transmitters 3 may be connected in parallel, and be placed on left earpiece 1, right earpiece 2 and on the headband 4. Preferably the IR transmitters 3 are placed on both sides of the headset, that is in the front side and at the back side of the headset, enabling a possibility of controlling the controlled device while standing back to it.

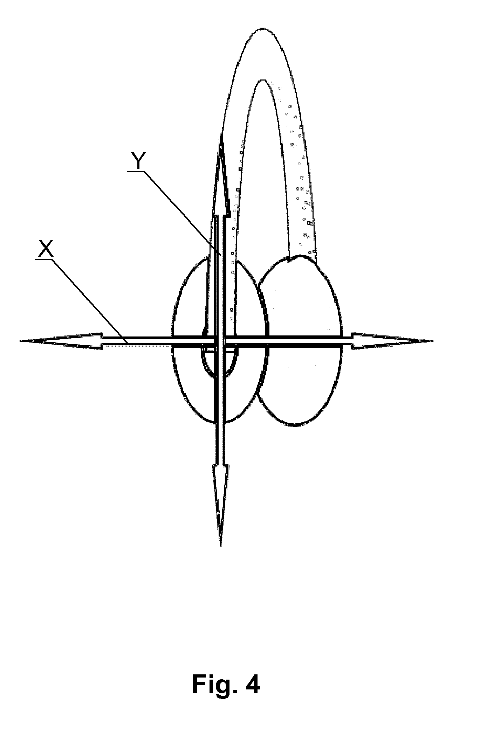

Fig. 4 shows an example of a coordinate system of the headset. The front of the headset can be understood as the position with positive X coordinates, and the back of the headset can be understood as the position with negative X coordinates. Analogously, the upward direction can be understood as the direction with increasing (positive) values of Y coordinates, and the downward direction can be understood as the direction with decreasing (negative) values of Y coordinates.

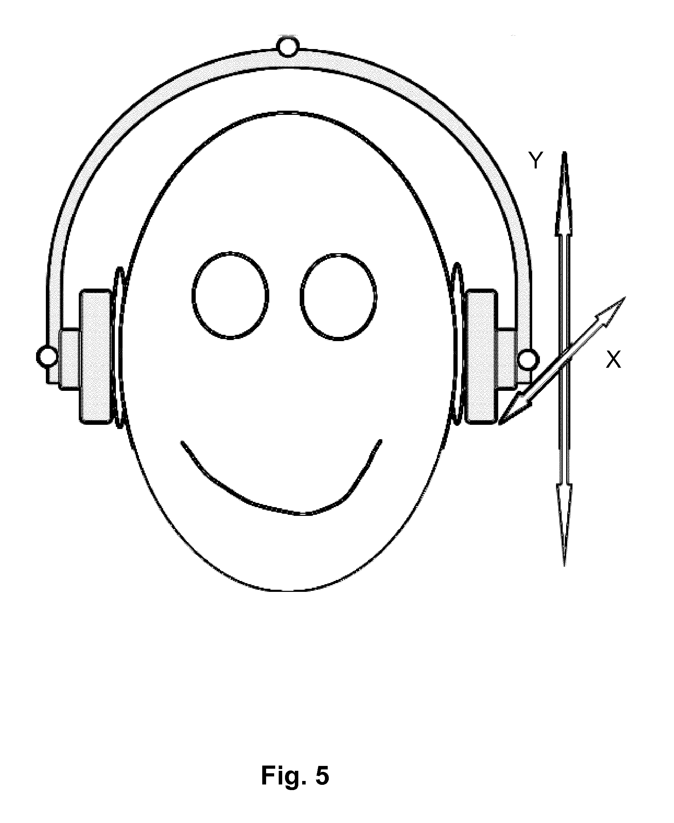

Fig. 5 shows an example of the coordinate system of the headset in relation to users head.

Furthermore, the headset may comprise a bidirectional communication unit 105. The bidirectional communication unit 105 communicates with the controlled device to send and receive data from the controlled device, as well as to receive and send sound to/from the controlled device.

Furthermore the headset may comprise a microphone 107 in order to be capable of communicating with a mobile phone and conducting a phone call. In such an embodiment, one or both control units 6, 7 can assume a function of receiving and declining a call controls. The wireless communication unit 105 is capable of transmitting sound received by the microphone 107, and commands received from control units 6, 7, to a mobile device. In the above situation the functions of the infrared communication unit 104 are performed by the wireless communication unit 105.

The locations of the pushbuttons cannot be seen when wearing the headset on a head. The control of the parameter groups can trigger playing an audio descriptor associated with given parameter through at least one earpiece. For example, the control units 6, 7 may comprise further sensors for detection of a finger being positioned over the button, for example accelerometers, gyroscopes, touch sensors or proximity sensors. After the contact or close distance is detected, an audio description of the function assigned to the input means 5 may be played through the earpieces. This feature allows the user to make a conscious selection of a function prior to its execution.

Furthermore, the input means 5 may have a form of touch sensors. After touching a sensor with a finger, a desired action is performed. The touch sensors may additionally comprise proximity sensors for detecting the presence of a finger above a certain touch button. Similarly as in the case of pushbuttons, after a finger presence is detected, an audio description of the function assigned to the touch sensor, above which a finger is present, may be played in the headset. Thus situations when an unwanted change of a function happens can be limited.

Furthermore, input means 5 may have a form of touchless sensors (e.g. proximity or optical sensors) which receive control instructions according to predefined input methods. These predefined methods may have a form of hand signaling (hand gestures) or hand movements. Thus a specific hand sign or hand movement may correspond to adequate adjustment of parameters of the controlled device, and/or to selection a function whose parameters are to be adjusted.

Furthermore, input means 5 may have a form of accelerometers or gyroscopes which receive control instructions performed by the user by means of tapping the left or the right earpiece. The accelerometer or gyroscope is capable of detecting the tap command as a sudden vibration of the earpiece. The user may therefore input a first type of command by a single tap, a second type of command by a double tap, a third type of command by a triple tap etc.

One preferable method may use specific hand movements that may be performed in a vertical or horizontal axis with respect to the headband 4 of a headset. As depicted in Fig. 5, the vertical axis Y is aligned with the headband 4, it may be understood as a line going from a chin towards a forehead of a user's head. The horizontal axis X can be assumed as the axis perpendicular to the headband 4, which may be understood as a line going from the back of a head towards eyes of a user's head.

The input means 5 of the control unit 6, 7 of the earpiece 1, 2 can be responsible for increasing and decreasing parameters, or selecting of a function when detecting movement along the horizontal axis. Choosing a function can be understood as changing a parameter from the first parameter group that is responsible for activating specific function while adjusting the parameter of a selected function can be understood as controlling a parameter from the second parameter group that corresponds to activated specific function.

Thus for example, a movement of a hand in a horizontal axis X, in a vicinity of the right earpiece control unit 7, in a direction from the back of a head towards eyes, may be associated with increasing the volume, while in a direction from the eyes towards a back of a head may be associated with decreasing the volume. Similarly movements in vicinity of the left earpiece control unit 6 in the vertical axis Y in the direction from a chin towards the forehead may signify a program number increase while movements in direction from a forehead towards a chin may signify a program number decrease.

Another preferable method introduced in the headset control units 6, 7 with input means 5 in a form of sensors may use hand gestures recognition. The first control unit 6 may comprise input means 5 for choosing a specific function when recognizing gesture associated with this specific function, while the second control unit 7 may comprise input means 5 for adjusting the parameter of the function chosen by the first control unit 6. Sensors for detecting gestures and differentiating between them are known in the art.

For example, when a first control unit 6 is responsible for choosing a function based on the number of fingers shown in a gesture in front of the first control unit's 6 sensors, the second control unit 7 sensors are responsible for recognizing and executing instruction associated with the gesture made in front of the other earpiece, which can be for example twist of a hand resembling a use of control knob to adjust a parameter value.

There are also other functions or parameter adjustments which may be codified in a form of hand signs. Thus sensors can be able to recognize the shape the hand is formed in. For example the aforementioned standby function may be selected using two hands - first hand being open and still in front of the left earpiece control unit 6 and second hand being open and still in front of the right earpiece control unit 7 for a certain amount of time.

Additional exemplary function may be a "Mute" option. It may be performed by a signature of a closing hand in front of one of earpiece's control unit 6 or 7. It means at first showing an open hand than closing it, in a vicinity of a proximity sensor located on one or both of earpiece's control units 6, 7.

Furthermore, the headset may combine the use of different kind of input means 5. Thus, for example, the left earpiece control unit 101 may comprise input means 5 in form of sensors which recognize hand signs and correspondingly choose adequate function, while the right earpiece control unit 102 may comprise input means 5 in form of a knob having a form of rotating ring around the right earpiece 2.

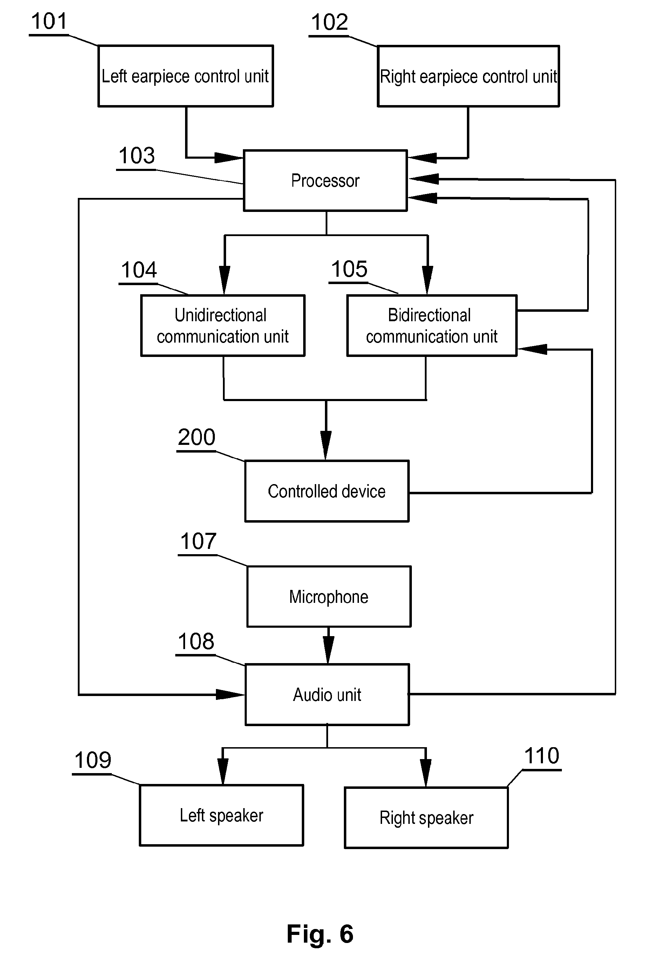

Fig. 6 shows a schematic diagram of a headset for controlling an external device, where the processor 103, being a main processing unit, controls the wireless communication unit 105, the infrared communication unit 104 and the audio unit 108. The wireless communication unit 105 receives and transmits signals to/from the controlled electronic appliance 200 and translates them to the processor 103, which further distributes them to the audio unit 108. The audio unit 108 receives signals from the processor 103 and transforms and sends them to the speakers 109, 110 located in both earpieces. The audio unit 108 also collects signals form the microphone 107 and sends them to the processor 103 which next transforms them and sends to the wireless communication unit 105. The left earpiece control unit 101 and the right earpiece control unit 102 are connected to the processor 103, which interprets signals coming from the input means 5 and sends them to the infrared communication unit 104.

By combining a remote control unit and headphones into one functional device, the user is no longer forced to hold it in hand or pay attention to its button layout. Even while moving around with headphones on the head, the user does not have to remember about additional controller. Consequently, the hands of the user are unoccupied and can be utilized for example to operate another device. At the same time, utilizing both earpieces as a separate means for setting selected parameters allows for more intuitive and less complicated operation.

It should be noted that present disclosure is applicable to a variety of different embodiments and should not be limited to the embodiments and applications presented herein. For example different shapes and sizes of earpieces or headband can be applied, different arrangements of input means. Additional functions or parameter adjustments options can be additionally implemented.

While the invention presented herein has been depicted, described, and has been defined with reference to particular preferred embodiments, such references and examples of implementation in the foregoing specification do not imply any limitation on the invention. It will, however, be evident that various modifications and changes may be made thereto without departing from the broader scope of the technical concept. The presented preferred embodiments are exemplary only, and are not exhaustive of the scope of the technical concept presented herein.

Accordingly, the scope of protection is not limited to the preferred embodiments described in the specification, but is only limited by the claims that follow.

In addition, any combination of the appended claims in envisaged in the present application.

## Claims

1. A headset for controlling an electronic appliance, comprising a first earpiece (1) and a second earpiece (2), **characterized in that** it further comprises
- a first control unit (6) associated with input means (5) located in the first earpiece (1);
- a second control unit (7) associated with input means (5) located in the second earpiece (2);
- wherein the input means (5) comprise sensors for detecting hand-performed actions of a user of the headset;
- communication means (104, 105) for connecting with the electronic appliance, wherein the connection allows to control selected parameters of the electronic appliance, said selected parameters being divided into at least a first parameter group and a second parameter group;
- wherein the first control unit (6) is configured to control the first parameter group upon detection of a predefined hand-performed action with respect to the input means (5) located in the first earpiece (1);
- and wherein the second control unit (7) is configured to control the second parameter group upon detection of a predefined hand-performed action with respect to the input means (5) located in the second earpiece (2).

2. The headset according to claim 1, wherein the first parameter group comprises selection of a function, and the second parameter group comprises selection of a parameter of the selected function.

3. The headset according to any previous claim, wherein the parameter groups are assigned dynamically based on detection of predefined conditions.

4. The headset according to any previous claim, wherein the control of the parameter groups triggers playing an audio descriptor associated with control parameter through at least one earpiece.

5. The headset according to claim 1, wherein the input means (5) are pushbuttons.

6. The headset according to claim 1, wherein the input means (5) are touch sensors.

7. The headset according to claim 1, wherein the input means (5) are proximity sensors.

8. The headset according to claim 1, wherein the input means (5) are optical sensors.

9. The headset according to claim 1, wherein the input means (5) are gyroscopes or accelerometers.
